# EUROPEAN PATENT APPLICATION

(11) **EP 3 723 051 A1**
(43) Date of publication of application: **14.10.2020**
(21) Application number: 19168130.3
(22) Date of filing: 09.04.2019
(51) Int. Cl.: G06T 17/00, G06F 17/50

(54) **RENDERING OF IMAGES OF BUILDINGS**

(71) Applicant: Scheerlinck, Nielsen, 9880 Aalter (BE)
(72) Inventor: Scheerlinck, Nielsen, 9880 Aalter (BE)
(74) Representative: Tomkins & Co

(57) **Abstract**

A system is described for rendering an image of a building comprising: a processor configured to: receive one or more data inputs indicating maximum allowable dimensions of a building; output a first rendered image of the building based on the maximum allowable dimensions; process a plurality of design constraints for the building; output a second rendered image of the building by applying at least one of the plurality of the processed design constraints to the first rendered image such that the first rendered image is altered based on the constraint to create the second rendered image.

## Description

### Field of the Invention

The invention relates to the rendering of an image of a building. In particular, it relates to 2D and 3D rendering of a building in software based on a series on inputs defining the building and its surroundings.

### Background to the Invention

The design and construction of buildings is a very time intensive process. Even the design and construction of quite small buildings can take many months or even years to bring to completion, especially when one factors in the time given to securing the required planning permissions for a given building. There are computer implemented tools which architects and planners use when designing a building which can assist in the creation of models of a building. However, these tools tend to provide for the design of building in isolation from their surroundings and without adequate allowance given to constraints such as regulatory constraints on building size and type. Furthermore, the tools are generally very labour intensive requiring a large amount of input from the user to create a model or image a building.

A system to simplify the modelling of buildings would be an improvement over the state of the art.

### Summary of the Invention

The present invention provides a system for rendering an image of a building comprising: a processor configured to: receive one or more data inputs indicating maximum allowable dimensions of a building; output a first rendered image of the building based on the maximum allowable dimensions; process a plurality of design constraints for the building; output a second rendered image of the building by applying at least one of the plurality of the processed design constraints to the first rendered image such that the first rendered image is altered based on the constraint to create the second rendered image.

This is advantageous as it provides an illustrative model of a building which takes account of design constraints and further provides that the model may be updated or refined based on either further data input regarding the building and/or regarding the design constraints. It further reduces the labour required to produce a rendered image as the system can automatically create a rendered image based on some initial inputs rather than requiring a user to draw every aspect of a new building.

The plurality of design constraints may comprise data relating to at least one of, but not limited to:
- the location of the building;
- the site context of the building;
- a sun path orientation with respect to the building;
- a building regulation associated with the location of the building;
- a building offset factor;

This is advantageous as it provides that a number or common design constraints can be inputted and processed by the system. This provides that the rendered image is one of a building that is in compliance with given constraints.

The first and second rendered image may comprise a 2D plan of the building. This is advantageous as it provides an initial broad interpretation of a building which can be analysed by a user with a view to further enhancing the building.

The first and second rendered image may comprise a 3D isometric image of the building. This is advantageous as it provides a more complete and robust image of a building which again can be analysed by a user with a view to further enhancing and ultimately optimising the building within the boundaries of the design constraints.

The first rendered image may be altered based on the constraint to create the second rendered image such that the second rendered image displays the building comprising a plurality of subdivided units. This is advantageous as it provides a means of visualisation to the user of how the space within a building may be subdivided in a number of apartments or offices.

The number of subdivided units may be maximised within the limits of the plurality design constraints. This is advantageous as it provides for optimisation of the space within a building.

The processor may be further configured to apply surface detail to the second rendered image. This is advantageous as it provides a means for visualisation to a user of how a finished building may look.

The surface detail may comprise at least one of surface texture, colouring, surface details, surface decoration. This is advantageous as it provides granular detail to a user of how a finished building may be look or be further modified within its environment.

The processor may be further configured to: receive one or more data inputs relating to a geographical area; analyse the data to locate one or more sites in the geographical area suitable for a building of the maximum allowable dimensions and output the location of the one or more sites. This is advantageous as it provides for isolating sites and areas in a region which are suitable for siting a new building.

Further provided is a method for rendering an image of a building comprising: inputting maximum allowable dimensions of a building; outputting a first rendered image of the building based on the maximum allowable dimensions; processing a plurality of design constraints for the building; outputting a second rendered image of the building by applying at least one of the plurality of the processed design constraints to the first rendered image such that the first rendered image is altered based on the constraint to create the second rendered image.

Further provided is a computer readable medium comprising instruction thereon which when executed causes a processor to perform the method for rendering the image of a building as described.

### Brief Description of the Drawings

Figure 1 shows an example of a 2D outline plan of building
Figure 2 shows an example of a 2D outline plan of a building incorporating a sun path orientation
Figure 3 shows an example of a 3D isometric image of a building indicating a design constraint of a maximum allowable height
Figure 4 shows an shows an example of an image of a building indicating a design constraint of building offset on site
Figure 5 shows and example of a first rendered image being altered based on a constraint to provide a second rendered image
Figure 6 shows an example of a rendered image of a finished building

### Detailed Description

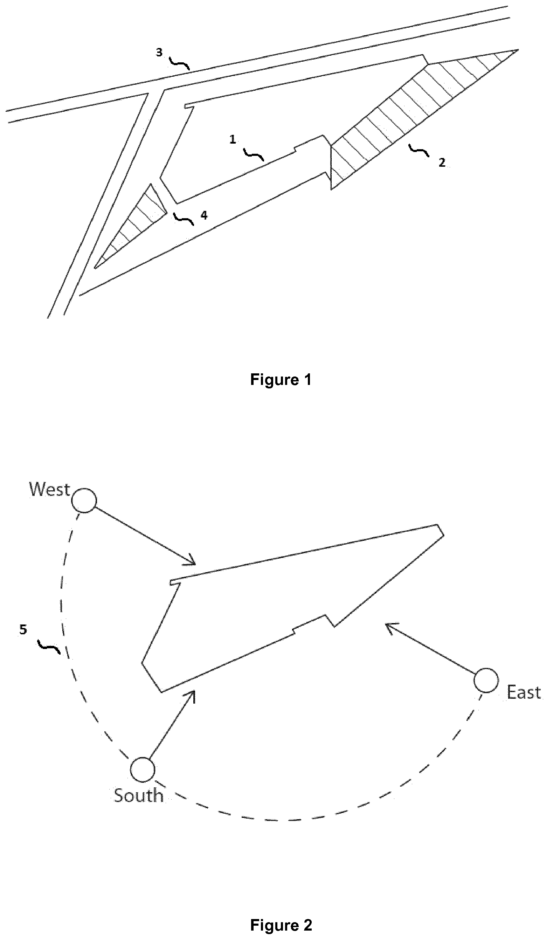

A system for rendering an image of a building is described. The system comprises a processor configured to receive one or more data inputs indicating maximum allowable dimensions of a building. The processor is further configured to output a first rendered image of the building based on the maximum allowable dimensions. The image may be output to an electronic display such as a monitor or may be output to a printer to produce hard copies of the image. In this manner, an outline plan of a building may be produced which provides a first impression of how a building will integrate into its surroundings. The outline plan may be as shown in **Figure 1****.** The plan shows the basic outline of the building 1 based on the data inputs indicating the maximum allowable dimension of the building. The maximum breadth and width of the building will be defined by the dimensions and shape of the site for the building. The plan may be highlighted in bold or a colour outline such that it stands out from the surrounding area.

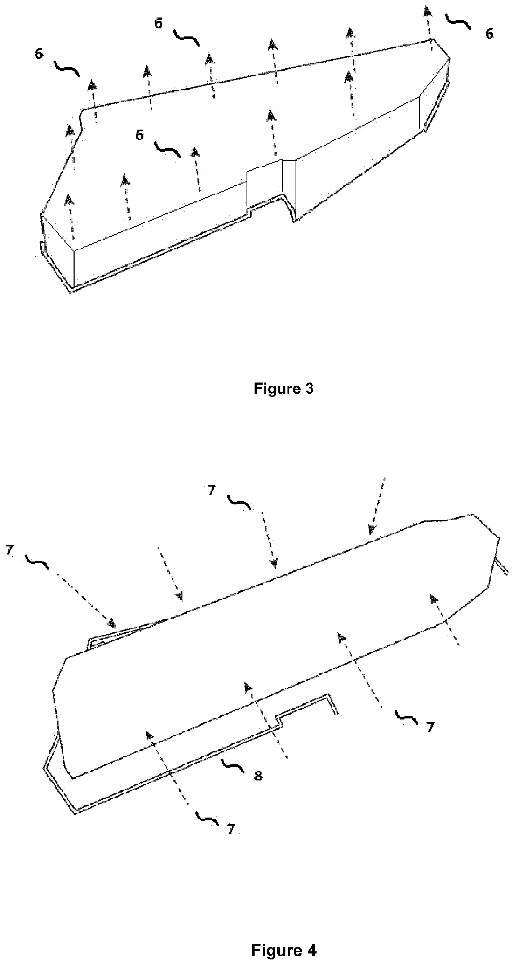

The processor is configured to process a plurality of design constraints for the building. The constraints may be input manually to the system or extracted from databases of building or environmental data. For example, an interface may be provided into which a user may input data describing the relevant constraints. Alternatively, information describing given constraints may be preloaded into the system for processing. Such information may include for example, building size regulations, fire regulations for a particular city, an area map of a region or a city. The constraints define aspects of the building such as its overall size including its maximum height, its orientation, its shape and its context, i.e. how it interacts with other buildings in its proximity and its surrounding environment. These constraints may include, but are not limited to, data relating to i) the location of the building; ii) the site context of the building: iii) a sun path orientation with respect to the building; iv) a building regulation associated with the location of the building; v) a building offset factor.
i) the location of the building; a building may only be built in an available space that is either not occupied or is soon not to be occupied by another building. Location data to be processed by the system may include information relating to a city development plan in which available sites, i.e. plots of available land, are identified by street name. The location data may comprise co-ordinates of available sites within a certain region. Location data may comprise addresses or post code data from a property register. The location data may be further processed to provide all plots of available land for a given area. Location data relating to a city, for example from a city development plan, may be inputted to the system. The location data may be processed to provide an outline or list of all plots of available land in a region. A user may use an interface to select a plot and instruct the system to output a first rendered image of a building for the plot. The location data may be further processed to exclude land which is vacant but which is not available or suitable for development, for example industrial land or protected regions such as parklands. The location data may be scanned into the system from a map uploaded to the system in the form of co-ordinates. In addition, in the case where a site already has a volume or building on it, the system may calculate the building volume and analyse if the plot's use is being maximised. If not, the system can propose an optimal use for the site.
ii) the site context of the building: a building (or parts of a building) may only be suitable for orientation in a certain direction based on what surrounds the building and what the building may be anticipated to overlook. Thus, this places a constraint on the size and orientation of a buildings elevation in different directions. Furthermore, data with respect to the surrounding environment may be processed to include information on subterranean pipework, power and telecommunication lines, train lines, roads and sewerage systems. The size, shape and orientation of surrounding buildings may also be processed. For example, with further reference to Figure 1, the building 1 is shown with its shape defined by an adjoining building 2, roads 3 and an area demarcating underlying pipework 4.
iii) a sun path orientation with respect to the building; the position and orientation of a building is typically defined to maximise the interaction of natural light with the building. As such, the path 5 of the sun with respect to a given building for a location may be processed to produce an image of a building in which the use of natural sunlight over the course of a day is maximised **(****Figure 2****).**
iv) a building regulation associated with the location of the building: building regulations may be processed and will have an effect on the type and size of a building which may be produced in a certain location. For example, with respect to **Figure 3****,** an image of a building is shown wherein a maximum allowable height is (shown by arrows 6) processed allowing an image to be produced based on this constraint. Such maximum allowable heights are typically defined in building regulations.
v) a building offset factor; it may not be possible to position a building such that it covers the maximum extent of a given site. In such case, with respect to **Figure 4****,** a building offset factor (indicated by arrows 7) may be applied whereby an image of a building is produced such that an offset from the site extremities 8 is shown. Such an offset may mitigate, for example, against noise or drainage issues.

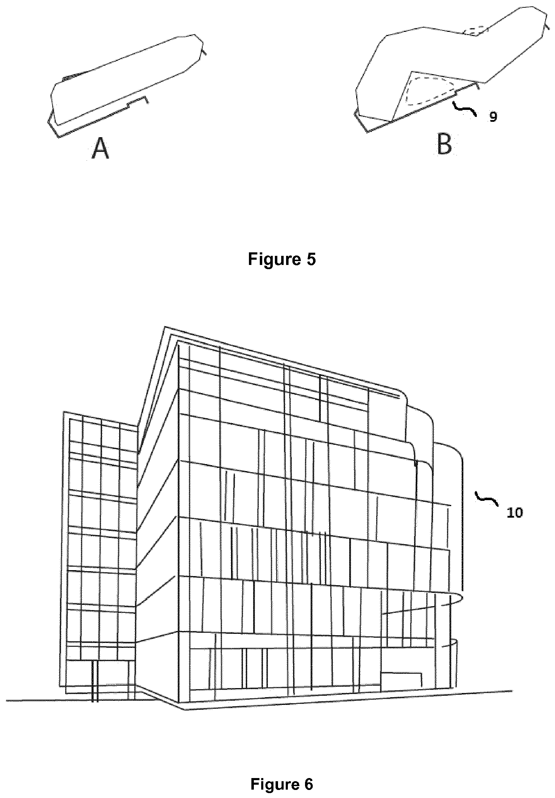

Other constraints which may be processed by the system and which can affect the appearance and shape of the building in the rendered image relate to issues with the form of the building. For example, the shape of the building may be altered. See, for example, **Figure 5A** wherein an original building shape is altered to give a new building shape as in **Figure 5B****.** The building shape may be altered to reduce the appearance of the building mass, to create open space (see for example the dashed outline area 9 in Figure 5B) and to reduce the effect of shadowing on surrounding buildings. Each of these constraints may be input as data to the system or derived from databases. Databases may include for example databases of building locations, databases of existing building dimensions, databases of existing building regulations, databases of fire and accessibility regulations.

The processor is configured to output a second rendered image of the building by applying at least one of the plurality of the processed design constraints to the first rendered image such that the first rendered image is altered based on the constraint to create the second rendered image. Furthermore, a number of the constraints may be processed to produce iterative rendered images which take each additional processed constraint into consideration. Once again, the images may be output to an electronic display such as a monitor or may be output to a printer to produce hard copies of the image.

An interface may be provided, for example on a display of a desk top computer or tablet device, which allows a user to see the effect on the rendered image of each processed constraint. For example, a user can toggle between images to see an image with a constraint applied and without a given constraint applied.

The rendered images may initially comprise a 2D plan of the building. As additional inputs are provided and additional constraints are processed, the image may take the form of a 3D isometric image of the building.

Furthermore, the processor may process the constraints to provide an image of the building comprising a plurality of subdivided units within the building. The "units" for example may represent an individual apartment or office space within the building. Each subdivided unit may itself have building constraints applied to it and a further iterative rendered image produced in which each unit is optimised with respect to size, orientation and context. Effectively, an optimal use of space within the building may be provided for based on a combination of constraints. The optimization may be controlled by the user by selecting or deselecting the constraints to be used to create the rendered building. Furthermore, the system may process location data to provide a list of available lands which are of sufficient size to accommodate a certain number of units. For example, location data can be processed to return the plots of available land within a region that can accommodate 100 units taking into the account the constraints associated with the plot.

The number of subdivided units may be maximised within the limits of the plurality design constraints. A user for example may wish to create a render of a building in which the number of one bedroom apartments is maximised within the constraints of a current building regulation. A user for example may wish to create a render of a building in which a set number of apartments of a given floor area is incorporated.

As well as providing for an image of a building to be rendered based on design constraints. The system provides for the aesthetics of the building to be visualised. As such, the processor may be further configured to apply surface detail, such as surface texture, colouring, surface details, surface decoration to the second rendered image (See for example building 10 in **Figure 6**).

The processor may be further configured to receive one or more data inputs relating to a geographical area; analyse the data to locate sites in the geographical area suitable for a building of the maximum allowable dimensions and output the location of the one or more sites. In this manner, the system thus provides for the processing of location data for all possible sites in a city or country. Accordingly, it provides a clear picture or overview of what can still be built in a region. This allows a user to analyse the impact a new building or buildings may have the city or country. For example, the system provides for analysis such as, but not limited to, traffic, distance from living to working, passage for shops, the direction in which a city is evolving, whether planning and regulation allows the city to prosper, whether the city can expand at the rate that the population is growing. Thus the system provides for urban planning as well as the analysis of an individual building.

The system described may take the form of a computer such as a desktop computer or laptop computer, mobile or tablet device. The processor may be housed within the computer and be configured, for example, via software or a hardware plugin to perform the steps described herein.

The words "comprises/comprising" and the words "having/including" when used herein with reference to the present invention are used to specify the presence of stated features, integers, steps or components but do not preclude the presence or addition of one or more other features, integers, steps, components or groups thereof.

It is appreciated that certain features of the invention, which are, for clarity, described in the context of separate embodiments, may also be provided in combination in a single embodiment. Conversely, various features of the invention which are, for brevity, described in the context of a single embodiment, may also be provided separately or in any suitable subcombination.

## Claims

1. A system for rendering an image of a building comprising: a processor configured to:
receive one or more data inputs indicating maximum allowable dimensions of a building;
output a first rendered image of the building based on the maximum allowable dimensions;
process a plurality of design constraints for the building;
output a second rendered image of the building by applying at least one of the plurality of the processed design constraints to the first rendered image such that the first rendered image is altered based on the constraint to create the second rendered image.

2. The system of claim 1 wherein the plurality of design constraints comprise data relating to at least one of:
- the location of the building;
- the site context of the building;
- a sun path orientation with respect to the building;
- a building regulation associated with the location of the building;
- a building offset factor.

3. The system of claim 1 or 2 wherein the first and second rendered image comprise a 2D plan of the building.

4. The system of claim 1 or 2 wherein the first and second rendered image comprise a 3D isometric image of the building.

5. The system of any preceding claim wherein the first rendered image is altered based on the constraint to create the second rendered image such that the second rendered image displays the building comprising a plurality of subdivided units.

6. The system of claim 5 such that number of subdivided units is maximised within the limits of the plurality design constraints.

7. The system of any preceding claim wherein the processor is further configured to apply surface detail to the second rendered image.

8. The system of claim 7 wherein the surface detail comprises at least one of surface texture, colouring, surface details, surface decoration.

9. The system of any preceding claim, wherein the processor is further configured to:
receive one or more data inputs relating to a geographical area;
analyse the data to locate one or more sites in the geographical area suitable for a building of the maximum allowable dimensions;
output the location of the one or more sites.

10. A method for rendering an image of a building comprising:
inputting maximum allowable dimensions of a building;
outputting a first rendered image of the building based on the maximum allowable dimensions;
processing a plurality of design constraints for the building;
outputting a second rendered image of the building by applying at least one of the plurality of the processed design constraints to the first rendered image such that the first rendered image is altered based on the constraint to create the second rendered image.

11. A computer readable medium comprising instruction thereon which when executed causes a processor to perform the method of claim 10.
